Europäisches Patentamt

(19) European Patent Office

Office européen des brevets

(11) Publication number: **0 074 604**
**B1**

# EUROPEAN PATENT SPECIFICATION

(45) Date of publication of patent specification: **27.12.85**

(51) Int. Cl.⁴: **H 03 K 19/195**

(21) Application number: **82108223.7**

(22) Date of filing: **07.09.82**

(54) **Circuit utilizing Josephson effect.**

(30) Priority: **10.09.81 JP 142748/81**
**10.09.81 JP 142749/81**
**14.09.81 JP 145313/81**

(43) Date of publication of application:
**23.03.83 Bulletin 83/12**

(45) Publication of the grant of the patent:
**27.12.85 Bulletin 85/52**

(84) Designated Contracting States:
**DE FR GB IT NL**

(56) References cited:
**EP-A-0 024 468**

**IBM TECHNICAL DISCLOSURE BULLETIN, vol.
24, no. 3, August 1981, pages 1545-1546, New
York (USA); S.M. FARIS et al.: "Compact
three-terminal Josephson switch".**

(73) Proprietor: **NEC CORPORATION**
**33-1, Shiba 5-chome, Minato-ku**
**Tokyo 108 (JP)**

(72) Inventor: **Sone, Junichi**
**c/o Nippon Electric Co., Ltd. 33-1, Shiba
Gochome**
**Minato-ku Tokyo (JP)**

(74) Representative: **Glawe, Delfs, Moll & Partner
Patentanwälte**
**Postfach 26 01 62 Liebherrstrasse 20**
**D-8000 München 26 (DE)**

## Description

### Background of the invention

The present invention relates to circuits utilizing the Josephson effect and, more particularly, to such a logic gate which has very short gate delay time and wide operational margins and is feasible for a high degree of integration.

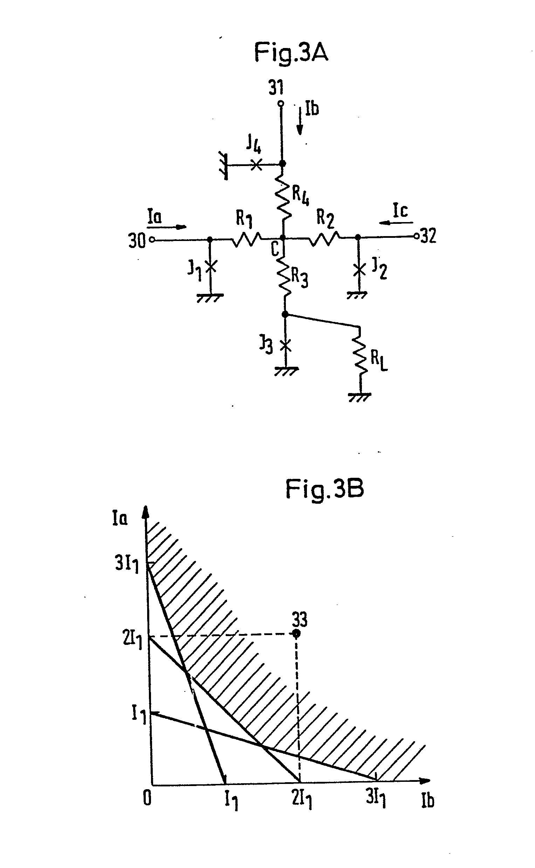

Various kinds of logic gates have been proposed using Josephson junctions to take advantage of their low power dissipation and high switching speeds. For example, refer to the paper "Josephson-Logic Devices and Circuits" by Tushar R. Gheewala, IEEE Transactions on Electron Devices, Vol. ED—27, No. 10, October 1980, pp. 1857—1869. Basic construction of the logic gate is of the interference type consisting of a plurality of Josephson junctions and inductances adapted to electrically connect the Josephson junctions. An input current is directly injected into the logic gate or electromagnetically coupled with a control line of the logic gate, thereby switching the gate to the voltage state. T. R. Gheewala describes in his paper "Josephson logic circuits based on nonlinear current injection in interferometer devices", Applied Physics Letter, Vol. 33, No. 8, pp. 781—783, a logic gate which is designed for wider margins and higher switching speeds. Figure 3(a) on page 782 of this paper shows an AND gate equipped with an interferometer gate which has two Josephson junctions having critical currents $I_{01}$ and $I_{02}$, respectively, and a series connection of inductances $L_1$ and $L_2$ having inductance values $L_1'$ and $L_2'$. The Josephson junctions are connected in parallel by the series connection of the inductances. One input $I_a$ is coupled to the node between the inductances $L_1$ and $L_2$ and the other $I_b$ to one end of the inductance $L_1$. To optimize the operation (operational margins) of this gate, the inductance values $L_1'$ and $L_2'$ and the critical currents $I_{01}$ and $I_{02}$ are chosen to satisfy equations:

$$L_1'I_{01}=L_2'I_{02} \qquad (1)$$

$$I_{02}(L_1'+L_2')=\phi_0 \qquad (2)$$

where $\phi_0$ indicates a natural constant called "magnetic flux quantum" and having a value of the order of 2.07 pH · mA. However, this logic gate is disadvantageous in various respects. Although the critical current should be small for reduction of the power dissipation as seen from the equation (2), the current $I_{02}$ and the inductance values $L_1'$ and $L_2'$ cannot be reduced at the same time so that a large chip area is required to attain the low power dissipation. Since the gate includes both inductances and Josephson junction capacitance, resonance phenomena is caused which should be damped for high speed operations. Furthermore, a gate of this kind tends to trap stray magnetic field when switching to its superconducting state; the trapped magnetic field would cause the gate to malfunction. These problems exist not only in the above-described AND gate but in all the logic gates of interference type.

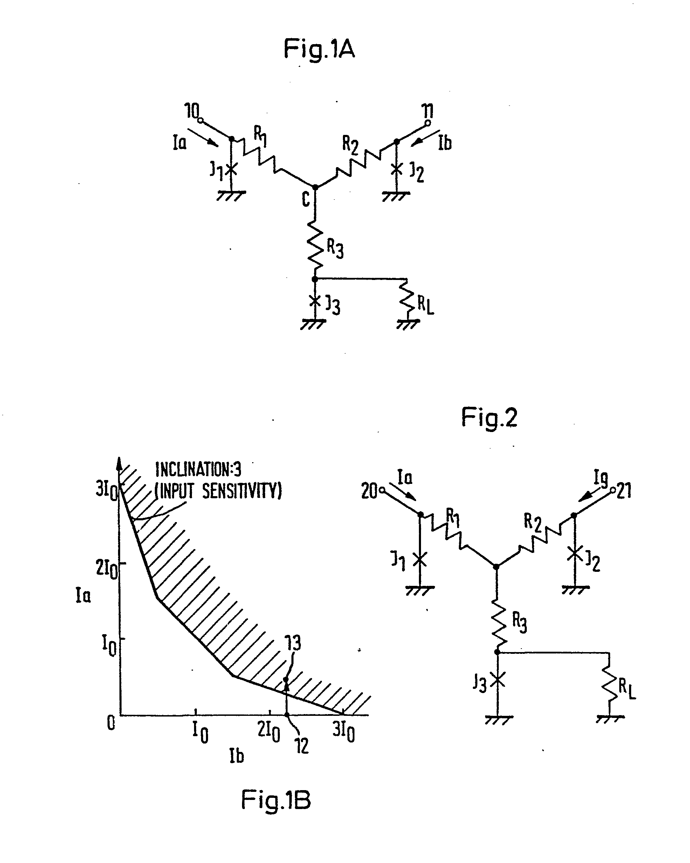

Meanwhile U.S. Patent No. 4,275,314 discloses an AND gate which is not provided with any inductance component to eliminate the drawbacks discussed above. The AND gate, as shown in Figure 3 of this U.S. Pat. specification, uses the circuit indicated in Figure 1 (named JAWS) as a one-input OR gate and cascades two such OR gates. When one input is supplied to the first stage JAWS, the first bias current fed to the first stage JAWS is coupled to the second stage JAWS as the second bias current. Upon arrival of the other input at the second stage JAWS, the second bias current is steered to the output side. This type of gate is still disadvantageous for the following reasons, though free from the drawbacks inherent in the AND gate previously described because of the absence of inductance component. First the cascaded JAWS result in the intricacy of circuit construction. Second, the input sensitivity is as small as 1 which makes the overdrive capability relatively small. It is thus difficult to speed up the switching actions (to shorten the gate delay time) or to decrease the turn-on delay time of the gate. In detail, output of a gate using Josephson junctions generally appears with the time constant of a load resistance $R_L$ and a Josephson junction capacitance C upon the lapse of a turn-on delay time after an input current has exceeded a threshold for the circuit operation. The turn-on delay time decreases in inverse proportion to the overdrive capability (defined by $(I_0—I_{th})/I_0$ where $I_0$ is the input current and $I_{th}$ the threshold current for a predetermined gate current). Refer to "Turn-on delay of Josephson Interferometer Logic Devices" IEEE Transactions on Magnetics, Vol. Mag-15, No. 1, January 1979, pp 562—565. Obviously, the overdrive capability increases with the input sensitivity which is defined by an inclination of a control characteristic line of the gate while the buildup time decreases as the input sensitivity becomes higher. Thus, it is desirable to make the input sensitivity as high as possible in order to speed up the switching actions of the gate (shorten the gate delay time). However, the input sensitivity of the above-mentioned gate is 1 which is relatively low to promote high speed switching.

Using the interferometer gate already discussed, there can be constructed an AND gate having two or more input lines, or a logic gate having a plurality of input lines and producing an output when input currents flow through a predetermined number or more of the input lines, e.g. a 2/3 logic gate in which an output appears when input currents flow through two or more of three input lines. In the 2/3 logic gate, for instance, a gate current is constantly fed to the Josephson junctions $J_1$ and $J_2$ through the inductances $L_1$ and $L_2$ of the interferometer gate, respectively, and the critical currents are selected such that the gate switches in response to the flow of input currents through two or more of the three input lines.

With this construction, however, not only the problems peculiar to the first-mentioned prior art gate remain unsolved but the input current margins are narrow and it is difficult to realize a highly integrated circuit. In detail, supposing that the minimum input current necessary for switching a gate under the supply of a gate current is $I_t$, the range (margins) of the input current $I_{in}$ required for operation of the 2/3 logic gate is quite narrow, not less than $I_t/2$ but not more than $I_t$. In the aspect of actual production, however, the input current margins will be still narrower in view of the lack of uniformity of critical current and inductance among integrated circuits. Moreover, the need for three input lines for magnetic coupling in the gate cannot be met without rendering the device design quite difficult, because it is hard to equalize the degrees of magnetic coupling between the input lines and the inductances. These are the problems also existing in multi-input AND gates.

Summary of the invention

It is an object of the present invention to provide a circuit utilizing the Josephson effect which is feasible for high integration and free from resonance due to the capacitance of Josephson junctions.

It is another object of the present invention to provide a circuit utilizing the Josephson effect which is provided with wide operational margins and capable of high speed switching.

It is another object of the present invention to provide a two-input AND gate utilizing the Josephson effect which has the advantages mentioned above.

It is another object of the present invention to provide a multi-input logic gate utilizing the Josephson effect which has the various advantages mentioned above and produces an output when inputs come in through a predetermined number or more of multiple inputs.

It is another object of the present invention to provide an amplifier utilizing the Josephson effect which features all the advantages described above.

In accordance with one embodiment of the present invention there is provided a circuit comprising a first resistor, a second resistor and a third resistor having predetermined resistances $r_1$, $r_2$, $r_3$, respectively, and connected together at one end thereof, a first Josephson junction and a second Josephson junction having predetermined critical currents $I_{01}$ and $I_{02}$, respectively, and connected at one end to the other end of the first and second resistors, respectively, and a third Josephson junction having a predetermined critical current $I_0$ and connected at one end to the other end of the third resistor the other ends of said Josephson junctions being connected to a common reference potential. Such a circuit has an AND function whereby an output current may be derived from the node between the third resistor and the third Josephson junction when the first and second input currents are supplied at the same time, and it has an amplifying function whereby a predetermined gate current is constantly supplied from the other end of the second resistor and an output, which is an amplified version of an input current from the other end of the first resistor, appears at the node between the third resistor and the third Josephson junction.

In accordance with another embodiment of the present invention, there is provided a circuit utilizing the Josephson effect and having the multi-input AND function in which one or more further resistors are additionally connected at one end thereof to the node at which the first, second and third resistors are connected together, and a corresponding number of further Josephson junctions with a predetermined critical current are connected between the other end of a respective one of said further resistors and a common reference potential. Properly selecting the resistances, critical currents and input currents will provide a circuit having an M/N logic gate ($M \leq N$) function.

In accordance with another embodiment of the present invention there are provided circuits comprising a first resistor and a second resistor connected together at one end thereof and having predetermined resistances, respectively a first Josephson junction and a second Josephson junction connected at one end to the other end of the first and second resistors, respectively, and having predetermined critical currents, a third Josephson junction having a predetermined critical current and connected at one end to the junction of the first and second resistors, and a third resistor connected between the other end of the first and second resistors and having a predetermined resistance, the other end of said Josephson junctions being connected to a common reference potential. Such a circuit may have an AND function whereby an output appears at the node between the third Josephson junction and the first and second resistors when input currents are supplied to the other end of the first and second resistors at the same time, and may have an amplifying function whereby a predetermined gate current is caused to constantly flow from the other end of the second resistor and an output, which is an amplified version of an input current from the other end of the first resistor, appears at the node between the third Josephson junction and the first and second resistor.

Other objects and features of the present invention will become apparent from the following description when read with reference to the accompanying drawings.

Brief description of the drawings

Figures 1A and 1B are a diagram of a circuit with the two-input AND function embodying the present invention and a graph showing its control characteristics, respectively:

Figure 2 is a diagram of a circuit using the arrangement shown in Figure 1A and furnished with the amplifying function;

Figures 3A and 3B are a diagram of circuit with a 2/3 logic gate function according to another embodiment of the present invention and a graph showing its control characteristics, respectively;

Figures 4A and 4B are a diagram of a circuit with a two-input AND function according to still another embodiment of the present invention and a graph showing its control characteristics, respectively; and

Figure 5 is a diagram of a circuit having an amplifying function and using the arrangement shown in Figure 4A.

Detailed description of the preferred embodiments

Referring to Figure 1A of the drawings, an example of a two-input AND gate is illustrated. The AND gate shown includes three resistors $R_1$, $R_2$, and $R_3$ which are connected in Y configuration about a node C. Josephson junctions $J_1$ and $J_2$ are connected between the resistors $R_1$ and $R_2$, respectively and ground. A Josephson junction $J_3$ is connected between the resistor $R_3$ and ground while a load resistor $R_L$ is connected through an output line in parallel with the Josephson junction $J_3$. Critical currents $I_{01}$, $I_{02}$ and $I_{03}$ of the Josephson junctions, $J1$, $J_2$ and $J_3$ and resistances $r_1$, $r_2$ and $r_3$ of the resistors $R_1$, $R_2$ and $R_3$ are individually selected to satisfy relations:

$$I_{01}=I_{02}=I_{03}/2 \doteqdot I_0 \qquad (3)$$

$$r_1=r_2=2r_3 \qquad (4)$$

Suppose that one of input currents $I_a$ and $I_b$ is injected into the AND gate through one of input terminals 10 and 11, say the input current $I_a$ through the input terminal 10. Where the input current $I_a$ is preselected to be larger than $I_0$ defined by the equation (3), the Josephson junction $J_1$ becomes switched to the voltage state. Then, the input current flown through the resistor $R_1$ is injected into the Josephson junction $J_3$ by a proportion $2/3 \cdot I_a$ through the resistor $R_3$ and into the Josephson junction $J_2$ by a proportion $1/3 \cdot I_a$ through the resistor $R_2$, as defined by the equation (4). Here, the Josephson junctions $J_2$ and $J_3$ will remain in the zero voltage state to deliver no output current to the resistor $R_L$ if the following relations are satisfied:

$$\frac{I_a}{3} \leqq I_0 \qquad (5)$$

$$I_a > I_0 \qquad (6)$$

Injected into the AND gate after the input current $I_a$ is the input current $I_b$ through the input terminal 11 which is supposed to satisfy relations:

$$I_a/3 + I_b > I_0 \qquad (7)$$

$$I_a + I_b > 2I_0 \qquad (8)$$

Then, the condition (7) brings the Josephson junction $J_2$ into the voltage state to allow the input currents $I_a$ and $I_b$ to be steered into the Josephson junction $J_3$. The condition (8) then brings the Josephson junction $J_3$ into the voltage state so that the input currents $I_a$ and $I_b$ are passed through the output line to the load resistor $R_L$. Where the supply of the input current $I_b$ occurs before that of the input current $I_a$, the above description will also apply if $I_a$ and $I_b$ are replaced with each other.

Figure 1B is a graph showing control characteristics of the logic gate provided by the relations (5), (6), (7) and (8) and their versions with $I_a$ and $I_b$ interchanged. The hatched area in the graph indicates the voltage state. It will be seen from the graph that when only one of the input currents $I_a$ and $I_b$ is supplied, the logic gate is not switched to the voltage state if the input current is smaller than $3I_0$; when both the input currents $I_a$ and $I_b$ are supplied and have the same magnitude, the logic gate is switched to the voltage state if $I_a=I_b \geqq I_0$. Generally, operational margins of a logic gate for the AND function increases as the input current $I_a(=I_b)$ necessary for the transition of the logic gate to the voltage state under the supply of both the currents $I_a$ and $I_b$ grows smaller than the input current $I_a$ or $I_b$ necessary for it under $I_a$ or $I_b$ only.

Thus, the logic gate of this embodiment has wide operational margins and, as will be seen from Figure 1B, its input sensitivity is as high as 3 which promotes high speed switching. Furthermore, in the logic gate according to this embodiment, there is no limitation as indicated by the equation (2), but the Josephson critical currents and resistances need only to satisfy the relations (3) and (4). The logic gate on the substrate, therefore, can be designed very small to the ability of lithography. The absence of inductances eliminates the resonance due to the Josephson junction capacitance and requires no additional provision against resonance in the circuit design. Since the logic gate is not of the superconducting loop type, it would not be affected in operation even when trapped stray magnetic fields in the ground plane.

The current injection type logic gate of this embodiment is also usable as a current amplifier due to its high gain characteristic. An amplifier application will be described with reference to Figure 2.

Referring to Figure 2, a predetermined current $I_g$ is constantly caused to flow from an input terminal 21. Considering the margins, the current $I_g$ is preset to 75% of $3I_0$. The operation point, therefore, may be the one indicated by 12 in the control characteristic shown in Figure 1B. In this situation, the minimum input current $I_a$ required for the transition of the logic gate to the voltage state is 0.25 $I_0$. Neglecting leak currents of the Josephson junctions under the voltage state, the logic gate will provide an output current expressed as $3I_0 \times 0.75 + 0.25I_0$ which in turn

provide a current gain of 10. In practice, the input current $I_a$ will be set at a larger value than $0.25I_0$ in consideration of the margins and, accordingly, the operation point of the gate circuit under the voltage state will be the one corresponding to 13 shown in Figure 1B.

Another embodiment of the logic gate of the present invention will be described hereunder which is constructed to produce an output when input currents are supplied through a predetermined number or more of a plurality (three or more) of input lines.

Referring to Figure 3A, there is shown a 2/3 logic gate which has input terminals 30, 31 and 32 and produces an output at the load resistor $R_L$ when input currents are supplied to two or more of the three input terminals. Basically, the logic gate shown in Figure 3A is constructed by connecting one end of a resistor $R_4$ to the node C of the AND gate indicated in Figure 1A and connecting a Josephson junction $J_4$ between the other end of the resistor $R_4$ and ground. It will be seen that a logic gate with four or more inputs can be designed as desired employing the same concept.

The logic gate shown in Figure 3A will be operated as follows. For the simplicity of description, the Josephson junctions $J_1$, $J_2$, $J_3$ and $J_4$ are assumed to be common in critical current $I_1$ and the resistors $R_1$, $R_2$, $R_3$ and $R_4$ common in resistance.

Let it be supposed that input currents $I_a$, $I_b$ and $I_c$ have been supplied sequentially to the respective input terminals 30, 31 and 32 in the order named. The input current $I_a$ having a value larger than the Josephson critical current $I_1$ switches the Josephson junction $J_1$ to the voltage state and is thereby trisected into the Josephson junctions $J_2$, $J_3$ and $J_4$. In order that the logic gate may not be switched under the above condition, $I_a$ and $I_1$ are chosen to have relations:

$$I_a/3 < I_1 \qquad (9)$$

$$I_a > I_1 \qquad (10)$$

Thereafter, the input terminal 31 is supplied with the input current $I_b$ which meets a condition:

$$I_a/3 + I_b > I_1 \qquad (11)$$

Then, the Josephson junction $J_4$ is switched to the voltage state so that the input currents $I_a$ and $I_b$ are individually bisected and steered into the Josephson junctions $J_2$ and $J_3$. At this instant, the Josephson junctions $J_2$ and $J_3$ become switched to the voltage state if there holds a relation:

$$I_a + I_b > 2I_1 \qquad (12)$$

This allows the composite input current $I_a + I_b$ to flow out into the output line which terminates at the load resistor $R_L$. Though the other input current $I_c$ may thereafter be injected through the input terminal 32, it is simply steered into the output line through the resistors $R_2$ and $R_3$ because all the Josephson junctions $J_1$, $J_2$, $J_3$ and $J_4$ have been switched to the voltage state. As a result, the input current $I_a + I_b + I_c$ is coupled to the load resistor $R_L$ through an output line. The same operation procedure, except for the interchange of $I_a$ and $I_b$, will occur when $I_b$ is injected into the logic gate before $I_a$.

The resulting control characteristics of the logic gate shown in Figure 3A is graphically represented in Figure 3B. The hatched area of the graph indicates the voltage state of the logic gate. While the input currents $I_a$ and $I_b$ have been assumed to be coupled to the logic circuit before the input current $I_c$, it will be understood that the control characteristics shown in Figure 3 also applies to a case wherein the currents $I_a$ and $I_c$ are supplied before the current $I_b$ or a case wherein the currents $I_b$ and $I_c$ are supplied before the current $I_a$, except for the substitution of $I_a$ and $I_b$ by $I_a$ and $I_c$ or by $I_b$ and $I_c$. This is because the logic gate shown in Figure 3A is symmetric with respect to the input currents $I_a$, $I_b$ and $I_c$. Indicated by the numeral 33 in Figure 3B is the operation point of the logic gate provided by the supply of input currents $I_a$ and $I_b$ whose magnitude is $2I_1$.

It will be seen that the logic gate shown in Figure 3A is properly operable as long as the magnitude $I_0$ of the input currents $I_a$, $I_b$ and $I_c$ is in a relation:

$$I_1 < I_0 < 3I_1 \qquad (13)$$

The margins of the input current is as wide as $2I_1 \pm 50\%$. Incidentally, the margins of the input current of the prior art 2/3 logic gate which relies on an interferometer is not more than $0.75I_t \pm 33.3\%$. Moreover, as shown in Figure 3A, the logic gate is fully symmetrical in structure with respect to the input currents $I_a$, $I_b$ and $I_c$, and requires no attention to the uniformity of the magnetic coupling between input currents and inductances, so that the complex device design is avoided. Apart from these outstanding advantages, the absence of inductances as described in relation with Figure 1A permits the logic gate of Figure 3A to be made small, highly integrated and freed from an implement against resonance.

It will be apparent in the circuitry of Figure 3A that various values can be employed for the input currents, critical currents of the Josephson junctions, and resistances of the resistors. It will also be apparent that a multi-input AND gate can be constructed by selecting each input current and critical current such that when each input current is coupled to the corresponding input terminal, the associated Josephson junction becomes switched to the voltage state and the Josephson junction $J_3$ to the voltage state by the sum of all the input currents.

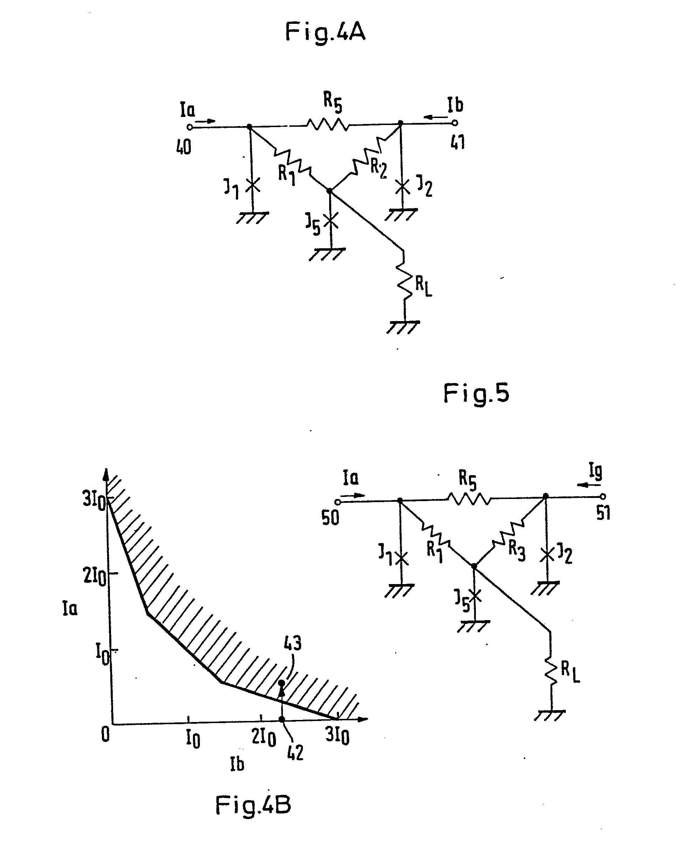

Referring to Figure 4A, a further embodiment of the present invention is shown which is an AND gate having two input terminals. The AND gate in Figure 4A is essentially similar to the AND gate in Figure 1A except that the resistor $R_3$ is omitted and replaced by a resistor $R_5$ which is connected between two input terminals. As shown, the AND gate comprises Josephson junctions $J_1$, $J_2$ and $J_5$ having critical currents $I_{01}$, $I_{02}$ and $I_{05}$, resistors $R_1$, $R_2$ and $R_5$ having resistances $r_1$, $r_2$ and $r_5$, a load resistor $R_L$ having a resistance $r_L$, and input terminals 40 and 41 to be supplied with input currents $I_a$ and $I_b$, respectively. In this embodiment, the critical currents $I_{01}$, $I_{02}$ and $I_{05}$ and the resistance $r_1$, $r_2$ and $r_5$ are individually chosen to satisfy relations:

$$I_{01}=I_{02}=I_{05}/2 \gtrsim I_0 \qquad (14)$$

$$r_1=r_2=2r_5 \qquad (15)$$

Suppose that one of input currents $I_a$ and $I_b$ is injected into the AND gate through one of the input terminals 40 and 41, say the input current $I_a$ through the input terminal 40. Where the input current $I_a$ is preselected to be larger than $I_0$ defined by the equation (14), the Josephson junction $J_1$ becomes switched to the voltage state. Then, the input current flown through the resistor $R_1$ is injected into the Josephson junction $J_5$ by a proportion $2/3 \cdot I_a$ through the resistor $R_1$ and into the Josephson junction $J_2$ by a proportion $1/3 \cdot I_a$ through the resistor $R_5$, as defined by the equation (15). Here, the Josephson junctions $J_2$ and $J_5$ will remain in the zero voltage state to deliver no output current to the load resistor $R_L$ if the following relations hold:

$$\frac{I_a}{3} \leqq I_0 \qquad (16)$$

$$I_a > I_0 \qquad (17)$$

Injected into the AND gate after the input current $I_a$ is the input current $I_b$ through the input terminal 41 which is supposed to meet relations:

$$I_a/3 + I_b > I_0 \qquad (18)$$

$$I_a + I_b > 2I_0 \qquad (19)$$

Then, the condition (18) brings the Josephson junction $J_2$ into the voltage state to allow the input currents $I_a$ and $I_b$ to be injected into the Josephson junction $J_5$. The condition (19) then brings the Josephson junction $J_5$ into the voltage state so that the input currents $I_a$ and $I_b$ are steered through an output line to the load resistor $R_L$. Where the supply of the input current $I_b$ occurs before that of the input current $I_a$, the above description will also apply if $I_a$ and $I_b$ are replaced by each other.

Figure 4B is a graph similar to Figure 1B and shows control characteristics of the logic gate provided by the relations (16) to (19) and their versions with $I_a$ and $I_b$ interchanged. It will be seen from the graph that when only one of the input currents $I_a$ and $I_b$ is supplied, the logic gate is not switched to the voltage state if the input current is smaller than $3I_0$; when both the input currents $I_a$ and $I_b$ are supplied and have the same magnitude, the logic gate is switched to the voltage state if $I_a=I_b \geqq I_0$. Thus, like the AND gate shown in Figure 1A, the AND gate of Figure 4A has wide operational margins and is capable of high speed switching. It is apparent that all the advantages discussed in connection with the circuitry of Figure 1A are applicable to the circuitry of Figure 4A.

Thus, the logic gate shown in Figure 4A is also usable as a current amplifier due to its high gain characteristic. Such an application is illustrated in Figure 5. As shown, a predetermined current $I_g$ is constantly caused to flow from an input terminal 51. Considering the margins, the current $I_g$ is preset to 75% of $3I_0$. The operation point under this condition may be the one indicated by the numeral 42 in Figure 4B. In this situation, the minimum input current $I_a$ from an input terminal 50 required for the transition of the logic gate to the voltage state is $0.25I_0$. Neglecting leak currents of the Josephson junctions under the voltage state, the logic gate will provide an output current expressed as $3I_0 \times 0.75 + 0.25I_0$ which in turn provide a current gain of 10. In practice, the input current $I_a$ will be set at a larger value than $0.25I_0$ in consideration of the margins and, accordingly, the operation point of the gate circuit under the voltage state will be the one corresponding to 43 shown in Figure 5.

**Claims**

1. A circuit utilizing the Josephson effect, comprising a first resistor ($R_1$), a second resistor ($R_2$) and a third resistor ($R_3$) having predetermined resistances $r_1$, $r_2$, $r_3$, respectively, and connected together at one end thereof, a first Josephson junction ($J_1$) and a second Josephson junction ($J_2$) having predetermined critical currents $I_{01}$ and $I_{02}$, respectively, and connected at one end to the other end of said first and second resistors, respectively, and a third Josephson junction ($J_3$) having a predetermined critical current $I_{03}$ and connected at one end to the other end of said third resistor the other ends of the first, second and third Josephson junctions being connected to a common reference potential.

2. A circuit as claimed in claim 1, further comprising a fourth resistor ($R_L$) having a predetermined resistance and connected with the other end of said third resistor ($R_3$) in parallel to said third Josephson Junction ($J_3$).

3. A circuit as claimed in claim 1, further comprising a first input terminal (10) connected with the other end of said first resistor ($R_1$) and supplied with a first input current having an amplitude $I_1$ necessary for switching said first Josephson junction ($J_1$) to the voltage state, and a second input terminal (11) connected with the other end of said second resistor ($R_2$) and supplied with a second input current having an amplitude $I_2$ which is necessary for the sum of a component of said first input current and said second input current to switch said second Josephson junction ($J_2$) to the voltage state and necessary for the sum of said first and second input currents to switch said third Josephson junction ($J_3$) to the voltage state, said circuit having the AND function which allows an output current to derive from the node between said third resistor ($R_3$) and said third Josephson junction ($J_3$) when said first and second input currents are supplied at the same time.

4. A circuit as claimed in claim 1, further comprising a gate terminal (21) connected with the other end of said second resistor ($R_2$) and supplied with a gate current $I_g$ having an amplitude necessary to switch said second Josephson junction ($J_2$) to the voltage state, and an input terminal (20) connected with the other end of said first resistor ($R_1$) and supplied with an input current having an amplitude which is sufficient for the sum of a component of said gate current and said input current to switch said first Josephson junction ($J_1$) to the voltage state and necessary for the sum of said gate current and said input current to switch said third Josephson junction ($J_3$) to the voltage state, said circuit having the amplifying function whereby an output, which is an amplified version of said input current, appears at the node between said third resistor ($R_3$) and said third Josephson junction ($J_3$).

5. A circuit as claimed in claim 3, in which said circuit satisfies conditions:

$$I_{01}=I_{02}=I_{03}/2$$

$$r_1=r_2=2r_3$$

$$I_1/3 \leqq I_{01}$$

$$I_1 > I_{01}$$

$$I_1/3+I_2 > I_{01}$$

$$I_1+I_2 > 2I_{01}$$

6. A circuit as claimed in claim 1, comprising one or more further resistors ($R_4$) each having a predetermined resistance and connected at one end to the node (C) at which said first, second and third resistors are connected together, and a corresponding number of further Josephson junctions ($J_4$) each having a predetermined critical current and connected at one end to the other end of a respective one of said further resistors, and at the other end to said common reference potential.

7. A circuit as claimed in claim 6, further comprising a first input terminal (30) connected with the other end of said first resistor ($R_1$) and supplied with a first input current having an amplitude necessary for switching said first Josephson junction ($J_1$) to the voltage state, a second input terminal (32) connected with the other end of said second resistor ($R_2$) and

supplied with a second input current having an amplitude necessary for the sum of a component of said first input current and said second input current to switch said second Josephson junction ($J_2$) to the voltage state, and a respective further input terminal (31) connected with the other end of each of said further resistors ($R_4$) and supplied with a respective further input current having an amplitude which is necessary for the sum of components of other input currents and said respective further input current to switch the respective further Josephson junction ($J_4$) to the voltage state and necessary for the sum of all the input currents to switch said third Josephson junction ($J_3$) to the voltage state.

8. A circuit as claimed in claim 6 or 7, in which there is one said further resistor ($R_4$) and one said further Josephson junction ($J_4$).

9. A circuit as claimed in claim 6, further comprising N input terminals connected with the other ends of said first second and further resistors, respectively, and each being supplied with an input current having a predetermined amplitude, the resistances of said resistors, critical currents of said Josephson junctions and input current amplitudes being chosen such that an output appears at the node between said third resistor ($R_3$) and said third Josephson junction ($J_3$) when said input currents are supplied to M of said N input terminals at the same time, where M<N.

10. A circuit as claimed in claim 9, in which N=3 and M=2.

11. A circuit as claimed in claim 10, in which all sais resistances are the same as each other and all said critical currents have an identical value $I_0$, said circuit satisfying conditions:

$$I_1/3 < I_0$$

$$I_1 > I_0$$

$$I_1/3+I_2 > I_0$$

$$I_1+I_2 > 2I_0$$

12. A circuit utilizing the Josephson effect, comprising a first resistor ($R_1$) and a second resistor ($R_2$) connected together at one end thereof and having predetermined resistances $r_1$ and $r_2$, respectively, a first Josephson junction ($J_1$) and a second Josephson junction ($J_2$) connected at one end to the other end of the first and second resistors, respectively, and having predetermined critical currents $I_{01}$ and $I_{02}$, respectively, a third Josephson junction ($J_5$) having a predetermined critical current $I_0$ and connected at one end to the junction of said first and second resistors, and a third resistor ($R_5$) connected between the other ends of said first and second resistors and having a predetermined resistance $r_5$, the other ends of the first, second and third Josephson junctions being connected to a common reference potential.

13. A circuit as claimed in claim 12, further comprising a fourth resistor ($R_L$) having a predetermined resistance and connected in parallel to said third Josephson junction ($J_5$).

14. A circuit as claimed in claim 12, further comprising a first input terminal (40) connected with the other end of said first resistor ($R_1$) and supplied with first input current having an amplitude $I_1$ sufficient for switching said first Josephson junction ($J_1$) to the voltage state, and a second input terminal (41) connected with the other end of said second resistor ($R_2$) and supplied with a second input current having an amplitude $I_2$ which is sufficient for the sum of said second input current and a component of said first input current which flows through said third resistor ($R_5$) to switch said second Josephson junction ($J_2$) to the voltage state and sufficient for the sum of said first and second input currents to switch said third Josephson junction ($J_5$) to the voltage state.

15. A circuit as claimed in claim 12, further comprising a gate terminal (51) connected with the other end of said second resistor ($R_2$) and supplied with a gate current having an amplitude sufficient to switch said second Josephson junction ($J_2$) to the voltage state, and an input terminal (50) connected with the other end of said first resistor ($R_1$) and supplied with an input current having an amplitude which is sufficient for the sum of said input current and a component of said gate current which flows through said third resistor ($R_5$) to switch said first Josephson junction ($J_1$) to the voltage state and sufficient for the sum of said gate and input currents to switch said third Josephson junction ($J_5$) to the voltage state, said circuit having the amplifying function whereby an output, which is an amplified version of said input current, is picked up at the node to which said third Josephson junction ($J_5$) and said first resistor and second resistor are connected.

16. A circuit as claimed in claim 14, in which said circuit satisfies conditions:

$$I_{01} = I_{02} = I_0/2$$

$$r_1 = r_2 = 2r_5$$

$$I_1/3 \leqq I_{01}$$

$$I_1 > I_{01}$$

$$I_1/3 + I_2 > I_{01}$$

$$I_1 + I_2 > 2I_{01}$$

**Patentansprüche**

1. Schaltung mit Verwendung des Josephsoneffekts, mit einem ersten Widerstand ($R_1$) einem zweiten Widerstand ($R_2$) une einem dritten Widerstand ($R_3$), die vorbestimmte Widerstandswerte ($r_1$, $r_2$, $r_3$) haben, und die an einem ihrer Enden miteinander verbunden sind, einem ersten Josephson-Übergang ($J_1$) und einem zweiten Josephson-Übergang ($J_2$) mit vorbestimmten kritischen Strömen ($I_{01}$, $I_{02}$), die an einem ihrer Enden mit dem anderen Ende des ersten bzw. zweiten Widerstandes verbunden sind, und einem dritten Josephson-Übergang ($J_3$) mit einem vorbestimmten kritischen Strom ($I_{03}$), der mit einem seiner Enden mit dem anderen Ende des dritten Widerstandes verbunden ist, wobei die anderen Enden des ersten, zweiten und dritten Josephson-Übergangs mit einem gemeinsamen Bezugspotential verbunden sind.

2. Schaltung nach Anspruch 1, welche ferner einen vierten Widerstand ($R_L$) mit einem vorbestimmten Widerstandswert aufweist, der mit dem anderen Ende des dritten Widerstandes ($R_3$) parallel zum dritten Josephson-Übergang ($J_3$) verbunden ist.

3. Schaltung nach Anspruch 1, welche ferner einen Eingangsanschluß (10) aufweist, der mit dem anderen Ende des ersten Widerstandes ($R_1$) verbunden ist und mit einem ersten Eingangsstrom beaufschlagt wird, der eine Amplitude ($I_1$) hat, wie sie nötig ist zum Schalten des ersten Josephson-Übergangs ($J_1$) in den Spannungszustand, und einen zweiten Eingangsanschluß (11), der mit dem anderen Ende des zweiten Widerstandes ($R_2$) verbunden ist und mit einem zweiten Eingangsstrom beaufschlagt wird, der eine Amplitude ($I_2$) hat, wie sie nötig ist, daß die Summe der Komponenten des ersten Eingangsstroms und des zweiten Eingangsstromes den zweiten Josephson-Übergang ($J_2$) in den Spannungszustand schalten und daß die Summe des ersten und zweiten Eingangsstromes den dritten Josephson-Übergang ($J_3$) in den Spannungszustand schalten, wobei der Schaltkreis und UND-Funktion hat, die es ermöglicht, daß ein Ausgangsstrom am Knotenpunkt zwischen dem dritten Widerstand ($R_3$) und dem dritten Josephson-Übergang ($J_3$) abgezogen wird, wenn der erste und der zweite Eingangsstrom gleichzeitig zugeführt werden.

4. Schaltung nach Anspruch 1, welche ferner einen Gateanschluß (21) aufweist, der mit dem anderen Ende des zweiten Widerstandes ($R_2$) verbunden ist und einen Gatestrom ($I_g$) aufnimmt, der eine Amplitude hat, wie sie nötig ist, um den zweiten Josephson-Übergang ($J_2$) in den Spannungszustand zu schalten, und einen Eingangsanschluß (20), der mit den anderen Ende des ersten Widerstandes ($R_1$) verbunden ist und mit einem Eingangsstrom versorgt wird, der eine Amplitude hat, wie sie ausreichend ist, daß die Summe der Komponenten des Gatestromes und des Eingangsstromes den ersten Josephson-Übergang ($J_1$) in den Spannungszustand schaltet und wie sie nötig ist, daß die Summe des Gatestromes und des Eingangsstroms den dritten Josephson-Übergang ($J_3$) in den Spannungszustand schaltet, wobei die Schaltung eine Verstärkerfunktion hat, wodurch ein Ausgangssignal, welches eine verstärkte Version des Eingangsstromes ist, am Knotenpunkt zwischen dem dritten Widerstand ($R_3$) und dem dritten Josephson-Übergang ($J_3$) auftaucht.

5. Schaltung nach Anspruch 3, welche die Bedingung erfüllt:

$$I_{01}=I_{02}=I_{03}/2$$

$$r_1=r_2=2r_3$$

$$I_1/3 \leqq I_{01}$$

$$I_1>I_{01}$$

$$I_1/3+I_2>I_{01}$$

$$I_1+I_2>2I_{01}$$

6. Schaltung nach Anspruch 1, mit einem oder mehreren zusätzlichen Widerständen ($R_4$) jeweils mit einem vorbestimmten Widerstandswert, welche mit einem ihrer Enden mit dem Knotenpunkt (C) verbunden sind, an welchem der erste, zweite und dritte Widerstand miteinander verbunden sind, und mit einer entsprechenden Anzahl von weiteren Josephson-Übergängen ($J_4$), die jeweils einen vorbestimmten kritischen Strom haben und an einem ihrer Enden mit dem anderen Ende des jeweiligen weiteren Widerstandes verbunden ist, und mit ihrem anderen Ende mit dem gemeinsamen Bezugspotential.

7. Schaltung nach Anspruch 6, welche ferner aufweist einen ersten Eingangsanschluß (30), der mit dem anderen Ende des ersten Widerstandes ($R_1$) verbunden ist und mit einem ersten Eingangsstrom Beaufschlagt wird, der eine Amplitude hat, wie sie nötig ist, um den ersten Josephson-Übergang ($J_1$) in den Spannungszustand zu schalten, einen zweiten Eingangsanschluß (32), der mit dem anderen Endes des zweiten Widerstandes ($R_2$) verbunden ist und mit einem zweiten Eingangsstrom beaufschlagt wird, der eine Amplitude hat, wie sie nötig ist, für die Summe der Komponenten des ersten Eingangsstroms und des zweiten Eingangsstroms, damit diese den zweiten Josephson-Übergang ($J_2$) in den Spannungszustand schalten, und einen jeweiligen Eingangsanschluß (31), der mit dem anderen Ende eines jeden der weiteren Widerstände ($R_4$) verbunden ist und mit einem jeweiligen weiteren Eingangsstrom beaufschlagt wird, der eine Amplitude hat, wie sie nötig ist, daß die Summe der Komponenten der anderen Eingangsströme und des jeweiligen weiteren Eingangsstromes den jeweiligen weiteren Josephson-Übergang ($J_4$) in den Spannungszustand schalten, und daß die Summe all der Eingangsströme den dritten Josephson-Übergang ($J_3$) in den Spannungszustand schaltet.

8. Schaltung nach Anspruch 6 oder 7, bei welcher ein weiterer Widerstand ($R_4$) und eine weiterer Josephson-Übergang ($J_4$) vorgesehen sind.

9. Schaltung nach Anspruch 6, welche ferner aufweist N Eingangsanschlüsse, die mit den anderen Enden der ersten, zweiten bzw. weiteren Widerstände verbunden sind and jeweils mit einem Eingangsstrom mit vorbestimmter Amplitude beaufschlagt werden, wobei die Widerstandswerte der Widerstände, die kritischen Ströme der Josephson-Übergänge und die Eingangsstromamplituden so gewählt sind, daß ein Ausgangssignal am Knotenpunkt zwischen dem dritten Widerstand ($R_3$) und dem dritten Josephson-Übergang ($J_3$) auftritt, wenn die Eingangsströme gleichzeitig an M der N Eingangsanschlüsse zugeführt werden, wobei M<N.

10. Schaltung nach Anspruch 9, daß N=3 und M=2 ist.

11. Schaltung nach Anspruch 10, bei welcher sämtliche Widerstandswerte gleich sind und die kritischen Ströme den identischen Wert ($I_0$) haben und die Schaltung die Bedingung erfüllt:

$$I_1/3<I_0$$

$$I_1>I_0$$

$$I_1/3+I_2>I_0$$

$$I_1+I_2>2I_0$$

12. Schaltung mit Verwendung des Josephsoneffekts, mit einem ersten Widerstand ($R_1$) und einem zweiten Widerstand ($R_2$), die miteinander an einem ihrer Enden verbunden sind und jeweils vorbestimmte Widerstandswerte ($r_1$ bzw. $r_2$) haben, einem ersten Josephson-Übergang ($J_1$) und einem zweiten Josephson-Übergang ($J_2$), die an einem ihrer Enden mit dem anderen Ende des ersten bzw. zweiten Widerstandes verbunden sind und vorbestimmte kritische Ströme ($I_{01}$ bzw. $I_{02}$) haben, einen dritten Josephson-Übergang ($J_5$), der einen vorbestimmten kritischen Strom ($I_0$) hat und an einem Ende mit der Verbindung des ersten und zweiten Widerstandes verbunden ist, und einem dritten Widerstand ($R_5$), der zwischen den anderen Enden des ersten bzw. zweiten Widerstandes verbunden ist und einen vorbestimmten Widerstandswert ($r_5$) hat, wobei die anderen Enden des ersten, zweiten und dritten Josephson-Übergangs mit einem gemeinsamen Bezugspotential verbunden sind.

13. Schaltung nach Anspruch 12, welche ferner einen vierten Widerstand ($R_L$) mit vorbestimmtem Widerstandswert aufweist, der parallel zum dritten Josephson-Übergang ($J_5$) geschaltet ist.

14. Schaltung nach Anspruch 12, welche ferner einen Eingangsanschluß (40) aufweist, der mit dem anderen Ende des ersten Widerstandes ($R_1$) verbunden ist und mit einem ersten Eingangsstrom mit einer Amplitude ($I_1$) beaufschlagt wird, die ausreicht zum Schalten des ersten Josephson-Übergangs ($J_1$) in den Spannungszustand, und einen zweiten Eingangsanschluß (41), der mit dem anderen Ende des zweiten Widerstandes ($R_2$) verbunden ist und mit einem zweiten Eingangstrom mit einer Amplitude ($I_2$) beaufschlagt wird, die ausreicht, daß die Summe des zweiten Eingangsstromes und eine Komponente des ersten Eingangsstromes, welche durch den dritten Widerstand ($R_5$) fließt,

den zweiten Josephson-Übergang ($J_2$) in den Spannungszustand schaltet und daß die Summe des ersten und zweiten Eingangsstromes den dritten Josephson-Übergang in den Spannungszustand schaltet.

15. Schaltung nach Anspruch 12, welche ferner einen Gateanschluß (51) aufweist, der mit dem anderen Ende des zweiten Widerstandes ($R_2$) verbunden ist und mit einem Gatestrom beaufschlagt wird, der eine Amplitude hat, die ausreicht, um den zweiten Josephson-Übergang ($J_2$) in den Spannungszustand zu schalten, und einen Eingangsanschluß (50), der mit dem anderen Ende des ersten Widerstandes ($R_1$) verbunden ist und mit einem Eingangsstrom beaufschlagt wird der eine Amplitude hat, die ausreicht, daß die Summe des Eingangsstroms und einer Komponente des Gatestroms, die durch den dritten Widerstand ($R_5$) fließt, den ersten Josephson-Übergang ($J_1$) in den Spannungszustand schaltet, und daß die Summe aus Gatestrom und Eingangsstrom den dritten Josephson-Übergang ($J_5$) in den Spannungszustand schaltet, wobei die Schaltung eine Verstärkerfunktion hat und ein Ausgangssignal, welches eine verstärke Version des Eingangsstroms ist, am Knotenpunkt abgezogen wird, mit welchem der dritte Josephson-Übergang ($J_5$) und der erste und zweite Widerstand verbunden sind.

16. Schaltung nach Anspruch 14, welche die Bedingung erfüllt:

$$I_{01} = I_{02} = I_0/2$$

$$r_1 = r_2 = 2r_5$$

$$I_1/3 \leqq I_{01}$$

$$I_1 > I_{01}$$

$$I_1/3 + I_2 > I_{01}$$

$$I_1 + I_2 > 2I_{01}$$

**Revendications**

1. Circuit utilisant l'effet Josephson, comprenant une première résistance ($R_1$), une seconde résistance ($R_2$) et une troisième résistance ($R_3$) ayant des valeurs prédéterminées $r_1$, $r_2$, $r_3$, respectivement, et connectées ensemble à l'une de leurs extrémités, une première jonction Josephson ($J_1$) et une seconde jonction Josephson ($J_2$) ayant des courants critiques prédéterminés $I_{01}$, $I_{02}$, respectivement, et connectées à une extrémité à l'autre extrémité des première et seconde résistances, respectivement, et une troisième jonction Josephson ($J_3$) ayant un courant critique prédéterminé $I_{03}$ et connectée à une extrémité à l'autre extrémité de la troisième résistance, les autres extrémités des première seconde et troisième jonctions Josephson étant connectées à un potentiel de référence commun.

2. Circuit selon la revendication 1, comprenant en outre une quatrième résistance ($R_L$) ayant une valeur prédéterminée, et connectée avec l'autre extrémité de la troisième résistance ($R_3$) en parallèle à la troisième jonction Josephson ($J_3$).

3. Circuit selon la revendication 1, comprenant en outre une première borne d'entrée (10) connectée à l'autre extrémité de la première résistance ($R_1$) et alimentée avec un premier courant d'entrée ayant une amplitude $I_1$ nécessaire pour commuter la première jonction Josephson ($J_1$) à l'état de tension, et une seconde borne d'entrée (11) connectée à l'autre extrémité de la seconde résistance ($R_2$) et alimentée avec un second courant d'entrée ayant une amplitude $I_2$ qui est nécessaire pour la somme d'une composante du premier courant d'entrée et du second courant d'entrée afin de commuter la seconde jonction Josephson ($J_2$) à l'état de tension et nécessaire pour la somme des premier et second courants d'entrée afin de commuter la troisième jonction Josephson ($J_3$) à l'état de tension, le circuit ayant une fonction ET qui permet à un courant de sortie de provenir du noeud entre la troisième résistance ($R_3$) et la troisième jonction Josephson ($J_3$) lorsque les premier et second courants d'entrée sont fournis en même temps.

4. Circuit selon la revendication 1, comprenant en outre une borne de porte (21) connectée à l'autre extrémité de la seconde résistance ($R_2$) et alimentée avec un courant de porte $I_g$ ayant une amplitude nécessaire pour commuter la seconde jonction Josephson ($J_2$) à l'état de tension, et une borne d'entrée (20) connectée à l'autre extrémité de la première résistance ($R_1$) et alimentée avec un courant d'entrée ayant une amplitude qui est suffisante pour la somme d'une composante du courant de porte et du courant d'entrée afin de commuter la première jonction Josephson ($J_1$) à l'état de tension et nécessaire pour la somme du courant de porte et du courant d'entrée afin de commuter la troisième jonction Josephson ($J_3$) à l'état de tension, le circuit ayant la fonction d'amplification, d'où l'apparition d'une sortie, qui est une version amplifiée du courant d'entrée, au noeud entre la troisième résistance ($R_3$) et la troisième jonction Josephson ($J_3$).

5. Circuit selon la revendication 3, dans lequel le circuit satisfait les conditions:

$$I_{01} = I_{02} = I_{03}/2$$

$$r_1 = r_2 = 2r_3$$

$$I_1/3 \leqq I_{01}$$

$$I_1 > I_{01}$$

$$I_1/3 + I_2 > I_{01}$$

$$I_1 + I_2 > I_{01}$$

$$I_1 + I_2 > 2I_{01}$$

6. Circuit selon la revendication 1, comprenant une ou plusieurs autres résistances ($R_4$) ayant

chacune une valeur prédéterminée et connectées à une extrémité au noeud (C) auquel les première, seconde et troisième résistances sont connectées ensemble, et un nombre correspondant d'autres jonctions Josephson (J₄) ayant chacune un courant critique prédéterminé et connectées à une extrémité à l'autre extrémité d'une résistance respective parmi les autres résistances, et à l'autre extrémité à un potentiel de référence commun.

7. Circuit selon la revendication 6, comprenant en outre une première borne d'entrée (30) connectée à l'autre extrémité de la première résistance ($R_1$) et alimentée avec un premier courant d'entrée ayant une amplitude nécessaire pour commuter la première jonction Josephson ($J_1$) à l'état de tension, une seconde borne d'entrée (32) connectée à l'autre extrémité de la seconde résistance ($R_2$) et alimentée avec un second courant d'entrée ayant une amplitude nécessaire pour la somme d'une composante du premier courant d'entrée et du second courant d'entrée afin de commuter la seconde jonction Josephson ($J_2$) à l'état de tension, et une autre borne d'entrée respective (31) connectée à l'autre extrémité de chacune des autres résistances ($R_4$) et alimentée avec un autre courant d'entrée respectif ayant une amplitude qui est nécessaire pour la somme des composantes des autres courants d'entrée et de l'autre courant respectif d'entrée afin de commuter l'autre jonction respective Josephson ($J_4$) à l'état de tension et nécessaire pour la somme de tous les courants d'entrée afin de commuter la troisième jonction Josephson ($J_3$) à l'état de tension.

8. Circuit selon la revendication 6 ou la revendication 7, dans lequel il y a l'autre résistance ($R_4$) et l'autre jonction Josephson ($J_4$).

9. Circuit selon la revendication 6, comprenant en outre N bornes d'entrée connectées avec les autres extrémités des première, seconde et autres résistances, respectivement, et chacune étant alimentée avec un courant d'entrée ayant une amplitude prédéterminée, les valeurs des résistances, les courants critiques des jonctions Josephson et les amplitudes des courants d'entrée étant choisis de façon qu'une sortie apparaisse au noeud entre la troisième résistance ($R_3$) et la troisième jonction Josephson ($J_3$) lorsque les courants d'entrée sont fournis à M des N bornes d'entrée en même temps, où M<N.

10. Circuit selon la revendication 9, dans lequel N=3 et M=2.

11. Circuit selon la revendication 10, dans lequel toutes les résistances sont identiques et tous les courants critiques ont une valeur identique $I_0$, le circuit satisfaisant les conditions:

$$I_1/3 < I_0$$

$$I_1 > I_0$$

$$I_1/3 + I_2 > I_0$$

$$I_1 + I_2 > 2I_0$$

12. Circuit utilisant l'effet Josephson, comprenant une première résistance ($R_1$) et une seconde résistance ($R_2$) connectées à une extrémité et ayant des valeurs prédéterminées $r_1$ et $r_2$, respectivement, une première jonction Josephson ($J_1$) et une seconde jonction Josephson ($J_2$) connectées à une extrémité à l'autre extrémité des première et seconde résistances, respectivement et ayant des courants critiques prédéterminés $I_{01}$, et $I_{02}$, respectivement, une troisième jonction Josephson ($J_5$) ayant un courant critique prédéterminé $I_0$ et connectée à une extrémité à la jonction des première et seconde résistances, et une troisième résistance ($R_5$) connectée entre les autres extrémités des première et seconde résistances et ayant une valeur prédéterminée $r_5$, les autres extrémités des première, seconde et troisième jonctions Josephson étant connectées à un potentiel de référence commun.

13. Circuit selon la revendication 12, comprenant en outre une quatrième résistance ($R_4$) ayant une valeur prédéterminée et connectée en parallèle avec la troisième jonction Josephson ($J_5$).

14. Circuit selon la revendication 12, comprenant en outre une première borne d'entrée (40) connectée à l'autre extrémité de la première résistance ($R_1$) et alimentée avec un premier courant d'entrée ayant une amplitude $I_1$ suffisante pour commuter la première jonction Josephson ($J_1$) à l'état de tension, et une seconde borne d'entrée (41) connectée à l'autre extrémité de la seconde résistance ($R_2$) et alimentée avec un second courant d'entrée ayant une amplitude $I_2$ qui est suffisante pour la somme du second courant d'entrée et d'une composante du premier courant d'entrée qui traverse la troisième résistance ($R_5$) afin de commuter la seconde jonction Josephson ($J_2$) à l'état de tension et suffisante pour la somme des premier et second courants d'entrée afin de commuter la troisième jonction Josephson ($J_5$) à l'état de tension.

15. Circuit selon la revendication 12, comprenant en outre une borne de porte (51) connectée à l'autre extrémité de la seconde résistance ($R_2$) est alimentée avec un courant de porte ayant une amplitude suffisante pour pouvoir commuter la seconde jonction Josephson ($J_2$) à l'état de tension, et une borne d'entrée (50) connectée à l'autre extrémité de la première résistance ($R_1$) et alimentée avec un courant d'entrée ayant une amplitude qui est suffisante pour la somme du courant d'entrée et d'une composante du courant de porte qui traverse la troisième résistance ($R_5$) pour commuter la première jonction Josephson ($J_1$) à l'état de tension et suffisante pour la somme des courants de porte et d'entrée afin de commuter la troisième jonction Josephson ($J_5$) à l'état de tension, le circuit ayant la fonction d'amplification, d'où il résulte qu'une sortie, qui est une version amplifiée du courant d'entrée, est prélevée au noeud auquel la troisième jonction

Josephson ($J_5$) et la première résistance et la seconde résistance sont connectées.

16. Circuit selon la revendication 14, dans lequel le circuit satisfait les conditions:

$$I_{01}=I_{02}=I_0/2$$

$$r_1=r_2-2r_5$$

$$I_1/3 \leq I_{01}$$

$$I_1 > I_{01}$$

$$I_1/3+I_2 > I_{01}$$

$$I_1+I_2 > 2I_{01}$$

0 074 604

## Fig.1A

## Fig.1B

## Fig.2

1

## Fig.3A

## Fig.3B

## Fig.4A

## Fig.5

## Fig.4B